# FASCICULE DE BREVET EUROPEEN

(11) **EP 0 518 755 B1**
(45) Date de publication et mention de la délivrance du brevet: **10.03.1999**
(21) Numéro de dépôt: 92401593.6
(22) Date de dépôt: 10.06.1992
(51) Int. Cl.: C03C 17/00, C03C 17/22, C03C 17/245, C03C 17/34

(54) **Technique de formation par pyrolyse en voie gazeuse d'un revêtement essentiellement à base d'oxygène et de silicium**
Verfahren zur Formung einer Beschichtung, im wesentlichen aus Sauerstoff und Silicium, durch Pyrolyse in der Gasphase
Technique for forming a coating, essentially containing oxygen and silicium, by pyrolysis in the vapour phase

(30) Priorité: 14.06.1991 FR 9107284
(43) Date de publication de la demande: 16.12.1992
(73) Titulaire: SAINT-GOBAIN VITRAGE, 92400 Courbevoie (FR)
(72) Inventeur: Sauvinet, Vincent, SCAN GOBAIN GLASS A/S, DK-1550 Copenhague V (DK); Oudard, Jean-François, 60310 Thiescourt (FR)
(74) Mandataire: Muller, René

(56) Documents cités:
- EP-A- 174 727
- EP-A- 305 102
- WO-A-90/09883
- FR-A- 2 477 131

## Description

L'invention concerne une technique de dépôt, par pyrolyse d'un mélange gazeux, d'une couche de revêtement essentiellement à base d'oxygène, de silicium ainsi que de carbone à la surface d'un substrat en verre chaud.

Elle a pour objet les conditions dans lesquelles est effectué un tel dépôt, ainsi que le dispositif utilisé dans ce but, et plus particulièrement la buse permettant de distribuer et canaliser ledit mélange gazeux.

Elle a également pour objet le substrat ainsi revêtu, ainsi que ses applications à différents vitrages.

De telles techniques, employant des buses de distribution de gaz destinés à se décomposer par pyrolyse à la surface d'un ruban de verre sont déjà connues, notamment du brevet FR-2 314 152. Celui-ci préconise de placer une buse de distribution à l'intérieur de l'enceinte d'un bain de flottage, transversalement par rapport à l'axe de défilement du ruban de verre glissant à la surface du bain de métal fondu. Le flux gazeux émis par le dispositif d'injection de la buse est guidé le long d'un canal ayant une section en U, défini par les parois d'un bloc central flanqué de deux talons "avant" et "arrière" par rapport à l'axe de défilement du ruban. Le flux gazeux effectue de cette manière un trajet en écoulement laminaire à la surface du verre parallèlement à cet axe, trajet au cours duquel a lieu la pyrolyse d'éléments gazeux "précurseurs" appartenant à ce flux. Puis, le flux gazeux ainsi appauvri est évacué par un dispositif d'aspiration disposé en sortie du canal.

La demande de brevet français n° 91-01683, quant à elle, propose un type de buse permettant d'optimiser la circulation de ce flux gazeux à la surface du verre afin d'améliorer le rendement de la réaction de pyrolyse, en modifiant notablement la configuration du canal précédemment évoqué, notamment en surélevant un des talons et en prévoyant des dispositifs d'aspiration secondaires.

Effectuer le dépôt dans l'enceinte du bain de flottage implique nécessairement de placer le dispositif de pyrolyse de gaz à l'intérieur de celle-ci, en général plutôt dans sa "partie aval", c'est à dire quand le ruban de verre a déjà acquis sa stabilité dimensionnelle, présente de multiples avantages techniques :

Tout d'abord, le ruban de verre a une température parfaitement connue et maîtrisée tout au long du bain de flottage, ce qui garantit, au niveau du dispositif de pyrolyse, une température de verre à peu près constante, et appropriée à la décomposition des gaz utilisés habituellement, soit aux environs de 700°C. On évite alors d'avoir recours, comme c'est souvent le cas en plaçant le dispositif hors de l'enceinte, à une opération de réchauffage du verre.

De plus, si l'on envisage de déposer différentes couches de revêtements successivement sur le ruban de verre, par de multiples réactions de pyrolyse par exemple, il n'est souvent pas indifférent de pouvoir faire le premier dépôt dans l'enceinte de flottage. On limite ainsi l'encombrement spatial des équipements nécessaires à ces dépôts ultérieurs, en général disposés entre la sortie du bain de flottage du ruban jusqu'à son passage dans l'étenderie de recuisson, qui est une étuve permettant, par un contrôle de descente en température, de relâcher les contraintes internes du verre.

Cependant, lorsque l'on cherche à appliquer, dans l'enceinte de flottage, ce type de technologie au dépôt d'une couche à base d'oxygène, silicium et éventuellement de carbone et dont l'épaisseur soit significative, on se heurte à un obstacle, comme l'état de la technique le prouve :

Ainsi, les brevets EP-174 727 et GB-2 199 848 proposent tous deux un procédé pour fabriquer ce type de revêtement dans de telles conditions. Le premier document utilise comme gaz "précurseur", c'est-à-dire susceptible d'intervenir dans la pyrolyse, un mélange consistant en un silane constituant la source de silicium et en un composé donneur d'électrons, tel qu'un éthylénique. Si le dioxyde de carbone est également cité, il est cependant indiqué qu'il faux mieux éviter d'utiliser ce type de source extérieure d'oxygène.

En effet, d'après ce texte, la seule source d'oxygène susceptible de s'associer avec les atomes de silicium provenant de la décomposition du silane est le verre lui-même, dont une certaine proportion d'atomes d'oxygène serait à même de diffuser à la surface, phénomène supposé facilité par l'adsorption éventuelle du donneur d'électrons à ladite surface du verre. Selon cet enseignement, cette capacité à diffuser est fort limitée, ce qui conduit à obtenir des couches d'épaisseurs très modestes, inférieures à 50 nm. C'est pourquoi l'application de ces couches se cantonne au blocage de migrations ioniques, mais ces épaisseurs peuvent être jugées nettement insuffisantes pour agir de manière interférentielle et significativement sur l'aspect coloré en réflexion d'un substrat muni ultérieurement d'une seconde couche fonctionnelle. Or, il s'agit d'un domaine d'application très important.

Le deuxième document, par contre, propose, pour obtenir le même genre de revêtement, d'ajouter aux gaz "précurseurs" cités précédemment, un composé supplémentaire censé jouer le rôle d'une source d'oxygène "d'appoint", comme du dioxyde de carbone, ce dernier étant utilisé dans une proportion très élevée par rapport au silane. On obtient alors un revêtement dont l'épaisseur peut aller jusqu'à 80 nm. Cependant, introduire une telle quantité d'un composé oxydant dans une enceinte de flottage risque fort de perturber l'atmosphère de celle-ci, alors qu'elle présente, par des proportions bien contrôlées d'hydrogène et d'azote, un caractère réducteur propre à protéger de toute oxydation le bain de métal fondu.

Le but de l'invention est donc d'obvier aux inconvénients précités en proposant une technique de pyrolyse par voie gazeuse qui permette à la fois de procéder à l'intérieur de l'enceinte de flottage sans perturber son atmosphère, et d'obtenir un revêtement à base de silicium, d'oxygène et éventuellement de carbone dont l'indice de réfraction global soit inférieur à 2 et dont l'épaisseur puisse être largement supérieure à 50 nm.

Pour répondre à cet objectif, les auteurs de la présente invention se sont attachés à optimiser le temps de contact entre les gaz précurseurs et le verre, lors du trajet laminaire des gaz précédemment évoqué et défini par la partie du canal de guidage que l'on peut désigner sous le terme de "zone de dépôt", et ceci sans recourir au moindre composé oxydant.

Mais cette optimisation n'a pas été effectuée uniquement en prenant en compte le temps de diffusion des gaz précurseurs, du plafond du canal de guidage à la surface du verre, comme c'est usuellement pratiqué par des calculs relativement empiriques explicités ci-après, calculs qui conduisent à "traduire" en quelque sorte ce temps de diffusion nécessaire en longueur de zone de dépôt, en tenant compte des divers paramètres du dépôt.

Au contraire, les auteurs de l'invention, prenant comme hypothèse, même si le mécanisme de ce phénomène est encore mal élucidé, que la seule source d'oxygène provient du verre lui-même, ont voulu non plus définir ce temps de contact en fonction de la diffusion des gaz précurseurs, mais en fonction de celle de l'oxygène contenu dans le verre jusqu'à la surface de celui-ci. Ils n'ont alors utilisé qu'un silane et un éthylénique, et ont constaté, d'une manière surprenante, qu'en augmentant le temps de contact entre gaz précurseurs et verre, on peut en quelque sorte "amplifier" et à tout le moins favoriser cette diffusion d'oxygène dans l'épaisseur du verre.

En garantissant bien sûr les proportions suffisantes minimales de silane et d'éthylénique, on obtient alors selon l'invention le revêtement voulu à base d'oxygène, de silicium et de carbone avec l'indice de réfraction recherché et d'épaisseur très nettement supérieure à 50 nm, sans avoir recouru à une quelconque source d'oxygène supplémentaire.

Les auteurs de l'invention ont donc été à l'encontre de l'enseignement de l'état de la technique, puisqu'ils ont rendu possible le fait d'«extraire » du verre une quantité suffisante d'oxygène, celui-ci s'associant à la surface du verre avec le silicium et le carbone pour créer un revêtement d'épaisseur supérieure à 50 nm. Ils ont ainsi mis en évidence qu'il ne suffit pas de garantir en quelque sorte un « temps de contact minimum » entre les gaz précurseurs et le verre de manière à permettre à ceux-ci d'atteindre le verre par diffusion, ni de garantir une quantité de gaz précurseurs adéquate, pour obtenir un revêtement à l'épaisseur voulue. En effet, il s'avère nécessaire de prendre également en compte ce phénomène de diffusion-incorporation au revêtement des atomes d'oxygène, et pour cela aller bien au-delà de ce temps de contact minimum.

L'invention consiste donc en une technique de formation par pyrolyse en voie gazeuse d'un revêtement à base de silicium, d'oxygène et de carbone, à la surface d'un substrat en verre en mouvement, à partir d'un mélange gazeux précurseur essentiellement dépourvu de composé oxydant et comportant un silane et un composé éthylénique, de manière à ce qu'on maintienne le temps de contact entre ce mélange précurseur et le verre à une valeur T₁, supérieure à celle T₂ nécessaire au dépôt dudit revêtement si celui-ci était effectué à partir d'un mélange gazeux précurseur contenant un agent oxydant en contrôlant le temps de contact mélange précurseur/verre par l'adaptation de la longueur L de la « zone de dépôt » de manière à ce que la longueur de ladite zone de dépôt, exprimée en mètres, soit supérieure ou égale à 1,5 fois la vitesse V du substrat en verre, exprimée en mètres par seconde. Le revêtement ainsi obtenu a un indice de réfraction compris entre 1,45 et 2, de préférence entre 1,6 et 1,9 et surtout son épaisseur atteint des valeurs supérieures à 50 nm.

Différents paramètres peuvent entrer en jeu pour contrôler ce temps de contact. Selon l'invention, on adapte notamment la longueur de la zone de dépôt, ainsi que la vitesse du substrat en verre animé d'un mouvement.

De manière surprenante, on a constaté qu'en adaptant conjointement ces deux paramètres, notamment de manière à ce que la longueur de la zone de dépôt, exprimée en mètre, soit supérieure ou égale à 1,5 fois la vitesse du substrat, exprimée quant à elle en mètre par seconde, le revêtement obtenu peut avoir une épaisseur très nettement supérieure à 50 nm.

Ainsi, si l'on choisit une longueur de zone de dépôt comprise entre 0,2 et 0,4 m et une vitesse de substrat comprise entre 0,1 à 0,2 m/s, on obtient des revêtements ayant des épaisseurs d'au moins 50 nm et jusqu'à 90 nm.

L'avantage majeur de l'invention réside dans le fait que l'on peut obtenir ce type de revêtement par cette technique de dépôt au-dessus du ruban de verre lorsque celui-ci a une température d'environ 700°C, dans l'enceinte de flottage, sans risquer de porter atteinte à son atmosphère réductrice. Mais il va de soi, bien sûr, qu'une telle technique est a fortiori utilisable hors de cette enceinte.

L'invention concerne également un dispositif de pyrolyse en voie gazeuse pour appliquer la technique ci-dessus décrite, dans lequel la longueur L de la zone de dépôt est définie par le canal de guidage de la buse de distribution, et est égale à la portion du canal délimitant le trajet laminaire du mélange précurseur à la surface du substrat en verre, parallèlement à l'axe de défilement de celui-ci, longueur L adaptable en vue du contrôle du temps de contact mélange précurseur/verre et comprise entre 0,2 et 0,4 m.

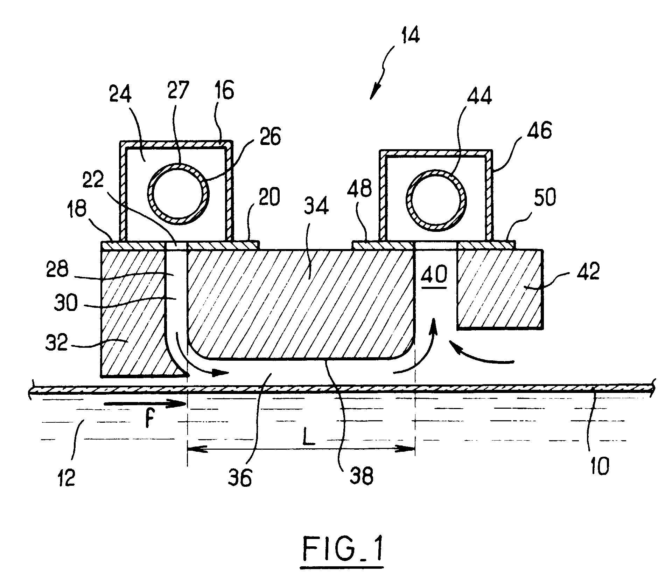

Les détails et caractéristiques avantageuses de l'invention vont maintenant ressortir des exemples non limitatifs suivants, illustrés par la figure 1 représentant la buse de distribution en coupe transversale d'un dispositif de pyrolyse utilisé dans la technique de dépôt par pyrolyse gazeuse selon l'invention.

On précise tout d'abord que l'on pourra se reporter, pour une description détaillée de l'ensemble d'un dispositif de pyrolyse de composés gazeux, aux brevets mentionnés précédemment. Dans la description suivante, on se limite aux éléments de la buse de distribution indispensables à la compréhension de l'invention, et l'on n'a pas respecté très exactement les proportions des divers éléments dessinés, afin de rendre la figure plus claire.

La figure 1 montre donc la buse de distribution d'un dispositif de pyrolyse à l'intérieur d'une enceinte de flottage non représentée. On y voit un ruban de verre 10 surnageant à la surface d'un bain de métal 12, habituellement formé d'étain en fusion, à l'intérieur d'une enceinte, non représentée, contenant le bain d'étain. Le verre se déverse sur le bain à partir d'un four de fusion de verre, également non représenté, situé à gauche de la figure 1, s'y étale jusqu'à former un ruban, lequel est extrait du bain à une vitesse constante dans le sens de la flèche f par des moyens extracteurs montés à la sortie du bain, du côté droit de la figure.

Au-dessus du ruban de verre 10 qui est d'une largeur d'environ 3,30 m, dans une zone du bain float où il a acquis une stabilité dimensionnelle, est montée une buse 14 pour l'amenée de gaz d'un revêtement. La buse est disposée transversalement au ruban de verre. Elle comprend un profilé 16, de section en U retourné, dont les bords des parois sont fixés sur des consoles horizontales 18, 20. Celles-ci définissent entre elles une ouverture 22 transversale par rapport au ruban.

Dans la chambre 24, définie par le profilé, est logé un conduit d'amenée de gaz 26 percé sur toute sa longueur de trous 27. Le gaz s'étend dans la chambre 24 où il se met à une pression uniforme et s'écoule à travers l'ouverture 22 vers un canal de guidage 28 de section en U. Ce canal comprend une chambre verticale d'injection 30 définie entre un talon profilé amont 32 et un bloc profilé central 34, une chambre horizontale 36, d'épaisseur constante, comprise entre le ruban de verre 10 et la face inférieure 38 du bloc central qui est plate, et une chambre verticale d'aspiration 40 définie entre le bloc central et un talon profilé aval 42.

Cette chambre horizontale 36 définit le trajet laminaire du mélange précurseur à la surface du verre, parallèlement à l'axe de défilement de celui-ci. Sa hauteur est de préférence comprise entre 3 et 6 mm.

A la sortie de la chambre 40, le gaz est aspiré par un conduit d'aspiration transversal 44 logé dans un profilé 46 de section en U retourné, fixé sur le bloc central et sur le talon amont par l'intermédiaire de consoles 48, 50.

Dans le cadre de l'invention, il s'agit donc d'adapter le temps de contact précurseurs/verre, notamment en faisant varier divers conditions du procédé de dépôt. Dans les exemples suivants, outre les variations de dépôt des gaz, on a fait varier la longueur L de la zone de dépôt de la chambre horizontale 36, qui correspond à la portion de trajet parallèle à l'axe de défilement du ruban du flux gazeux, ainsi que la vitesse du ruban de verre. Cette longueur L est en fait approximativement celle de la face inférieure 38 du bloc central, comme le montre la figure. La largeur de cette chambre est dans tous les exemples suivants d'environ 3,20 m ; valeur correspondant approximativement à la largeur du ruban "exploitable", après découpes latérales au-delà de l'enceinte de flottage.

Cette adaptation du dispositif de pyrolyse selon l'invention est clairement applicable à tous les types de buse classique, et nullement limité à celle représentée.

### EXEMPLES 1 A 7

Différents dépôts d'oxycarbure de silicium ont été effectués dans les exemples 1 à suivants avec ce type de buse. Les exemples 1 1 à concernent le revêtement d'un ruban de verre clair silico-sodo-calcique de 4 mm d'épaisseur. Les deux derniers concernent le revêtement d'un ruban de verre similaire, mais cette fois de 8 mm d'épaisseur.

On indique pour chacun des exemples les conditions de dépôt : Les débits Q des gaz intervenant dans la pyrolyse, soient le monosilane SiH₄, l'éthylène C₂H₄ ainsi que le gaz vecteur inerte azote N₂, sont des débits volumiques exprimés en litre/minute. Le rapport du débit de l'éthylène sur celui du monosilane est compris entre 4 et 10 et est de préférence égal à 7.

La vitesse du ruban de verre v est exprimée en mètre/seconde, et la longueur L de la zone de dépôt en mètre.

On précise en outre que n est l'indice de réfraction global du revêtement obtenu et e son épaisseur en nanomètre.

Toutes ces données concernant chacun des exemples sont regroupées dans le tableau ci-dessous :

| ex. | Q(SiH₄) | Q(N₂) | Q(C₂H₄) | L | v | n | e |
|---|---|---|---|---|---|---|---|
| 1 | 4 | 16 | 28 | 0,4 | 0,2 | 1,59 | 70 |
| 2 | 6 | 24 | 42 | 0,4 | 0,2 | 1,68 | 82 |
| 3 | 8 | 32 | 56 | 0,4 | 0,2 | 1,78 | 85 |
| 4 | 12 | 48 | 84 | 0,4 | 0,2 | 1,87 | 90 |
| 5 | 12 | 48 | 84 | 0,2 | 0,2 | 1,92 | 45 |
| 6 | 12 | 48 | 84 | 0,2 | 0,1 | 1,85 | 92 |
| 7 | 4 | 16 | 28 | 0,2 | 0,1 | 1,61 | 74 |

Dans les exemples 1 à 4 et 6 à 7, c'est donc le rapport 2 qui a été choisi entre la longueur L en mètres et la vitesse du ruban en mètres par seconde. On constate que cette longueur est nettement plus importante que celle que l'on pouvait déterminer précédemment en tenant compte de la diffusion du silane et de l'éthylénique, calcul que l'on donne brièvement : il s'agit d'affirmer que le temps t₁ d'écoulement du gaz le long de cette chambre horizontale 36 doit être supérieur au temps t₂ nécessaire aux gaz précurseurs pour diffuser sur toute la hauteur h de ladite chambre de la face 38 à la surface du ruban 10, en prenant comme données la vitesse d'écoulement du flux gazeux V, la hauteur h et le coefficient de diffusion moyen α,
on pose ainsi t₂ = h²/πα ; t₁ = L/V,
et on obtient alors la relation suivante : L > Vh²/(πα).

Or la comparaison des exemples 1 à 4 montre clairement que, même en augmentant considérablement les débits de gaz précurseurs, on n'augmente pas nécessairement dans les mêmes proportions l'épaisseur du revêtement obtenu, et qu'il y a donc un autre phénomène qui entre en jeu.

Proposer une buse de 0,4 mètre, longueur inhabituellement importante, permet cependant d'augmenter considérablement l'épaisseur du revêtement jusqu'à 90 nm. C'est donc au prix d'un temps de contact plus important, et non d'une quantité supérieure de gaz précurseurs qu'un tel résultat a été atteint.

De même, à débits gazeux égaux, les exemples 4, 5 et 6 prouvent qu'adapter la longueur L notamment en fonction de la vitesse du ruban permet de contrôler et d'augmenter l'épaisseur du revêtement. De là découle d'ailleurs un autre avantage substantiel de l'invention : en modulant cette longueur L, on peut alors obtenir les revêtements désirés avec des débits de produits gazeux plus modérés et par conséquent à moindre coût.

Il est à noter que, dans ces exemples, l'indice de réfraction global des revêtements obtenus est compris entre 1,59 et 1,92, ce qui constitue une gamme d'indices particulièrement adaptée pour permettre, en modulant également l'épaisseur de celui-ci, de jouer de manière interférentielle un rôle contre les irisations et/ou un rôle réducteur de l'aspect coloré d'un substrat ultérieurement revêtu d'une seconde couche fonctionnelle, telle qu'une couche à base d'oxyde métallique.

Plus généralement, ce type de revêtement, utilisé en "sous-couche" dans un empilement de couches minces sur un substrat en verre, permet de maîtriser l'aspect en réflexion colorée du substrat ainsi revêtu.

C'est pourquoi, on utilise avantageusement ce type de substrat muni du revêtement obtenu par la technique de l'invention dans différents types de vitrage, qu'ils soient simples, feuilletés ou multiples, ces vitrages possédant notamment des propriétés anti-solaires.

Ce dernier point va être illustré ci-dessous par les exemples comparatifs 8 et 9 ci-dessous.

### EXEMPLES 8 ET 9

L'exemple 8 concerne un substrat muni d'un revêtement en sous-couche conforme à l'exemple 2, ledit revêtement ayant donc un indice de réfraction de 1,68 et une épaisseur de 82 nm, sur lequel est déposée de manière connue, et notamment par pyrolyse également sur ligne, une seconde couche à fonction de protection solaire à base d'oxyde d'étain dopé au fluor SnO₂:F, cette seconde couche présentant quant à elle une épaisseur d'environ 300 nm.

L'exemple 9 est similaire à l'exemple 8, excepté qu'il ne comporte pas le revêtement en sous-couche selon l'invention. Il sert de référence.

Les données photométriques des substrats recouverts selon ces deux exemples sont regroupées dans le tableau ci-dessous. On précise que ces valeurs sont données en fonction de l'illuminant D₆₅, que la transmission lumineuse est donnée en pourcentages (T_{L}), ainsi que la transmission énergétique (T_{E}), la réflexion côté revêtement (R_{L}), et la pureté d'excitation correspondant à cette réflexion (pe). On indique de plus la longueur d'onde dominante de cette même réflexion (λ_{d}) en nanomètres, ainsi que l'émissivité (ε) des substrats.

| | T_{L} | T_{E} | R_{L} | pe | λ_{d} | ε |
|---|---|---|---|---|---|---|
| Exemple 8 | 79 | 72 | 14 | 12 | 539 | 0,17 |
| Exemple 9 | 82 | 72 | 11 | 4 | 510 | 0,17 |

Il ressort nettement de ce tableau que la présence de la sous-couche permet de diminuer par un facteur 3 la valeur de la pureté d'excitation en réflexion côté couches. On tend ainsi de manière particulièrement efficace à une neutralité en réflexion pour l'ensemble substrat-couches minces.

## Revendications

1. Technique de formation par pyrolyse en voie gazeuse d'un revêtement à rôle interférentiel à base de silicium, d'oxygène et de carbone, à la surface d'un substrat en verre en mouvement, à partir d'un mélange gazeux précurseur essentiellement dépourvu de composé oxydant et comportant un silane et un composé éthylénique, **caractérisée en ce qu'**on maintient le temps de contact entre ledit mélange précurseur et le verre à une valeur T₁ supérieure à celle T₂ nécessaire au dépôt dudit revêtement si celui-ci était effectué à partir d'un mélange gazeux précurseur contenant un agent oxydant en contrôlant le temps de contact mélange précurseur/verre par l'adaptation de la longueur L de la « zone de dépôt » de manière à ce que la longueur L de ladite zone de dépôt, exprimée en mètre, soit supérieure ou égale à 1,5 fois la vitesse v du substrat en verre exprimée en mètre par seconde, ce revêtement présentant un indice de réfraction compris entre 1,45 et 2 et une épaisseur supérieure à 50 nm.

2. Technique selon la revendication 1, **caractérisée en ce que** pour obtenir un revêtement avec une épaisseur comprise entre 50 et 90 nm, on impose un temps de contact gaz précurseur/verre correspondant à une longueur de zone de dépôt L comprise entre 0,2 et 0,4 mètre pour une vitesse du substrat en verre comprise entre 0,1 et 2,2 mètre par seconde.

3. Technique selon l'une des revendications 1 ou 2, **caractérisée en ce qu'**on procède au dépôt du revêtement à l'intérieur de l'enceinte du bain de flottage au-dessus du ruban de verre à une température d'environ 700°C.

4. Technique selon l'une des revendications 1 à 3, **caractérisée en ce que** le silane est le monosilane SiH4.

5. Technique selon l'une des revendications 1 à 4, **caractérisée en ce que** le composé éthylénique est l'éthylène C₂H₄.

6. Technique selon les revendications 4 et 5, **caractérisée en ce que** le rapport du débit volumique de l'éthylène sur celui du monosilane est compris entre 4 et 10, et de préférence d'environ 7.

7. Dispositif de pyrolyse en voie gazeuse pour appliquer la technique conforme à l'une des revendications précédentes, **caractérisé en ce que** la longueur L de la zone de dépôt est définie par le canal de guidage de la buse de distribution, et est égale à la portion du canal délimitant le trajet laminaire du mélange précurseur à la surface du substrat en verre, parallèlement à l'axe de défilement de celui-ci, longueur L adaptable en vue du contrôle du temps de contact mélange précurseur/verre et comprise entre 0,2 et 0,4 mètre.

8. Dispositif selon la revendication 7, **caractérisé en ce que** la longueur L de la zone de dépôt est égale à celle de la face inférieure du bloc central du canal de guidage de la buse de distribution, ce bloc étant en outre muni de deux talons amont et aval.

9. Dispositif selon la revendication 8, **caractérisé en ce que** la distance entre la surface du verre et la face inférieure du bloc central est comprise entre 3 et 6 mm.

10. Substrat revêtu d'une couche à rôle interférentiel à base de silicium, d'oxygène et de carbone par la technique de pyrolyse en voie gazeuse conforme à l'une des revendications 1 à 6, **caractérisé en ce que** ladite couche présente une épaisseur supérieure à 50 nm et un indice de réfraction compris entre 1,45 et 2 et de préférence entre 1,6 et 1,9.

11. Substrat revêtu selon la revendication 10, **caractérisé en ce qu'**il est en outre revêtu d'au moins une couche fonctionnelle mince transparente à base d'oxyde métallique tel que l'oxyde d'étain dopé au fluor, l'épaisseur et l'indice de réfraction du revêtement à base de silicium d'oxygène et de carbone étant ajustés afin de maîtriser l'aspect en réflexion colorée du substrat muni de ses couches.

12. Utilisation des substrats revêtus selon l'une des revendications 10 ou 11, dans des vitrages simples, multiples ou feuilletés à propriétés anti-solaires.

## Patentansprüche

1. Verfahren zur Bildung einer Beschichtung mit Interferenzfunktion auf der Basis von Silicium, Sauerstoff und Kohlenstoff auf der Oberfläche eines durchlaufenden Glassubstrats ausgehend von einem gasförmigen Vorläufer-Gemisch, das im wesentlichen keine oxidierende Verbindung, aber ein Silan und eine Ethylenverbindung enthält, durch Pyrolyse auf gasförmigem Wege, **dadurch gekennzeichnet, daß** die Zeit des Kontakts des Vorläufer-Gemisches mit dem Glas auf einem Wert T₁ gehalten wird, welcher größer als der zum Abscheiden der Beschichtung erforderliche T₂ ist, wenn dieses ausgehend von einem ein Oxidationsmittel enthaltenden gasförmigen Vorläufer-Gemisch erfolgte, indem die Kontaktzeit von Vorläufer-Gemisch/Glas durch Anpassung der Länge L der "Abscheidezone" derart geregelt wird, daß die in Metern ausgedrückte Länge L dieser "Abscheidezone" größer oder gleich dem 1,5fachen der in Meter pro Sekunde ausgedrückten Geschwindigkeit v des Glassubstrats ist, wobei diese Beschichtung einen Brechungsindex zwischen 1,45 und 2 und eine Dicke von über 50 nm besitzt.

2. Verfahren nach Anspruch 1, **dadurch gekennzeichnet, daß**, um eine Beschichtung mit einer Dicke zwischen 50 und 90 nm zu erhalten, eine Kontaktzeit von Vorläufergas/Glas eingestellt wird, die einer Länge L der Abscheidezone von 0,2 bis 0,4 Metern bei einer Geschwindigkeit des Glassubstrates von 0,1 bis 0,2 Metern pro Sekunde entspricht.

3. Verfahren nach Anspruch 1 oder 2, **dadurch gekennzeichnet, daß** die Beschichtung im Inneren der Wanne eines Floatbades auf dem Glasband bei einer Temperatur von etwa 700 °C aufgebracht wird.

4. Verfahren nach einem der Ansprüche 1 bis 3, **dadurch gekennzeichnet, daß** das Silan das Monosilan SiH₄ ist.

5. Verfahren nach einem der Ansprüche 1 bis 4, **dadurch gekennzeichnet, daß** die Ethylenverbindung Ethylen C₂H₄ ist.

6. Verfahren nach den Ansprüchen 4 und 5, **dadurch gekennzeichnet, daß** das Verhältnis des Volumendurchsatzes von Ethylen zu Monosilan 4 bis 10 und vorzugsweise etwa 7 beträgt.

7. Vorrichtung für die Pyrolyse auf gasförmigem Wege unter Anwendung des Verfahrens nach einem der vorhergehenden Ansprüche, **dadurch gekennzeichnet, daß** die Länge L der Abscheidezone durch den Führungskanal der Verteilerdüse festgelegt wird und gleich dem Teil des Kanals ist, der den laminaren Weg des Vorläufer-Gemisches auf der Oberfläche des Glassubstrates parallel zu dessen Durchlaufachse begrenzt, wobei die Länge L, um die Kontaktzeit von Vorläufer-Gemisch/Glas zu regeln, veränderbar ist und 0,2 bis 0,4 Meter beträgt.

8. Vorrichtung nach Anspruch 7, **dadurch gekennzeichnet, daß** die Länge L der Abscheidezone gleich der der Unterseite des zentralen Blocks des Führungskanals der Verteilerdüse ist, wobei dieser Block außerdem mit einem hinteren und einem vorderen Vorsatz versehen ist.

9. Vorrichtung nach Anspruch 8, **dadurch gekennzeichnet, daß** der Abstand zwischen der Glasoberfläche und der Unterseite des zentralen Blocks 3 bis 6 mm beträgt.

10. Substrat, das mit einer Schicht mit Interferenzfunktion und auf der Basis von Silicium, Sauerstoff und Kohlenstoff durch das Pyrolyseverfahren auf gasförmigem Wege gemäß einem der Ansprüche 1 bis 6 überzogen ist, **dadurch gekennzeichnet, daß** die Schicht eine Dicke von über 50 nm und einen Brechungsindex zwischen 1,45 und 2 und vorzugsweise 1,6 und 1,9 besitzt.

11. Beschichtetes Substrat nach Anspruch 10, **dadurch gekennzeichnet, daß** es außerdem mit mindestens einer transparenten dünnen Funktionsschicht auf der Basis von Metalloxid wie mit Fluor dotiertem Zinnoxid überzogen ist, wobei Dicke und Brechungsindex der Beschichtung auf der Basis von Silicium, Sauerstoff und Kohlenstoff eingestellt werden, um das Aussehen in Farbreflexion des mit seinen Schichten versehenen Substrats zu beherrschen.

12. Verwendung der beschichteten Substrate nach Anspruch 10 oder 11 in Einscheiben-, Mehrscheiben- oder Verbundverglasungen mit Sonnenschutzeigenschaften.

## Claims

1. Method for the formation by gaseous pyrolysis of an interference layer based on silicon, oxygen and carbon, on the surface of a moving glass substrate, from a precursor, gaseous mixture essentially free from any oxidiing compound and containing a silane and an ethylene compound, characterized in that the contact time between said precursor mixture and the glass is maintained at a value T₁ higher than that T₂ necessary for the deposition of said layer if it was carried out from a precursor, gaseous mixture containing an oxidizing agent by controlling the contact time between the precursor mixture and the glass by the adaptation of the length L of the "deposition area", so that the length L of said deposition area, expressed in metres, is equal to or greater than 1.5 times the speed v of the glass substrate, expressed in metres per second, said layer having a refractive index between 1.45 and 2 and a thickness exceeding 50 nm.

2. Method according to claim 1, characterized in that, in order to obtain a layer with a thickness between 50 and 90 nm, a precursor gas/glass contact time corresponding to a deposition area length L between 0.2 and 0.4 m is imposed for a glass substrate speed between 0.1 and 2.2 m/sec.

3. Method according to one of the claims 1 or 2, characterized in that the layer is deposited within the enclosure of the float bath above the glass ribbon at a temperature of approximately 700°C.

4. Method according to one of the claims 1 to 3, characterized in that the silane is monosilane SiH₄.

5. Method according to one of the claims 1 to 4, characterized in that the ethylene compound is ethylene C₂H₄.

6. Method according to claims 4 and 5, characterized in that the ratio of the volume flow of the ethylene to that of the monosilane is between 4 and 10 and is preferably approximately 7.

7. Gaseous pyrolysis apparatus for the application of the method according to one of the preceding claims, characterized in that the length L of the deposition area is defined by the guide channel of the distribution nozzle and is equal to the portion of the channel defining the laminar path of the precursor mixture on the surface of the glass substrate, parallel to the direction of travel thereof, said length L being adaptable with a view to controlling the contact time between the precursor mixture and the glass and is between 0.2 and 0.4 m.

8. Apparatus according to claim 7, characterized in that the length L of the deposition area is equal to that of the lower face of the central block of the guide channel of the distribution nozzle, said block also being provided with two upstream and downstream stubs.

9. Apparatus according to claim 8, characterized in that the distance between the glass surface and the lower face of the central block is between 3 and 6 mm.

10. Substrate covered with an interference layer based on silicon, oxygen and carbon by the gas pyrolysis method according to one of the claims 1 to 6, characterized in that said layer has a thickness exceeding 50 nm and a refractive index between 1.45 and 2 and preferably between 1.6 and 1.9.

11. Coated substrate according to claim 10, characterized in that it is also coated with at least one thin, transparent, functional layer based on metal oxide, such as fluorine-doped tin oxide, the thickness and refractive index of the layer based on silicon, oxygen and carbon being adjusted so as to control the appearance in coloured reflection of the substrate provided with its layers.

12. Use of coated substrates according to one of the claims 10 or 11, in single, multiple or laminated glazings having sun protection properties.
